# EUROPÄISCHE PATENTANMELDUNG

(11) **EP 1 460 435 A1**
(43) Veröffentlichungstag der Anmeldung: **22.09.2004**
(21) Anmeldenummer: 04004932.2
(22) Anmeldetag: 03.03.2004
(51) Int. Cl.: G01R 11/04, G01R 21/133

(54) **Verbrauchszähler mit austauschbarem Messmodul**

(30) Priorität: 19.03.2003 DE 10311995
(71) Anmelder: ITF Fröschl GmbH, 93194 Walderbach (DE)
(72) Erfinder: Zintl, Peter, 93092 Friesheim/Barbing (DE)
(74) Vertreter: Graf, Helmut, Dipl.-Ing.

(57) **Zusammenfassung**

Die Erfindung bezieht sich auf eine neuartige Ausbildung eines Verbrauchszählers, insbesondere Elektrizitätszählers, mit einem Signal- oder Meßwandler (4), der an seinem Ausgang dem Verbrauch entsprechende Meßwerte an ein Meßmodul (5) liefert, welches diese Meßwerte zu abrechnungsrelevanten Verbrauchswerten verarbeitet, wobei das Meßmodul austauschbar in einer Aufnahme (7) des Zählers vorgesehen ist.

## Beschreibung

Die Erfindung bezieht sich auf einen Verbrauchszähler gemäß Oberbegriff Patentanspruch 1.

Zur Erfassung und Abrechnung des Verbrauchs, beispielsweise des Verbrauchs an elektrischer Energie, aber auch des Verbrauchs an anderen Energie- und Verbrauchsarten, wie Gas, Wasser, Abwasser, Wärme, Preßluft usw. werden allgemein Verbrauchszähler eingesetzt.

Speziell bei Elektrizitätszählern ist es auch bekannt, aus den den jeweiligen Verbrauch bestimmenden physikalischen Istgrößen (Istspannungen und -strömen) in einem Messwandler diesen Größen proportionale Meßwerte zu bilden, die dann von einem analogen oder analog-digitalen Meßwerk zu Verbrauchswerten verarbeitet werden. Diese werden dann z.B. mittels eines oder mehrerer Rollenzählwerke oder aber auch elektronisch, beispielsweise mit einer oder mehreren LCD-Anzeigen angezeigt.

Nach geltendem Eichrecht müssen Verbrauchszähler für den Einsatz im geschäftlichen Verkehr geeicht sein. Die Zähler müssen weiterhin vor Ablauf der Eichgültigkeit oder bei einem Defekt ausgewechselt werden. Ein solcher Zählerwechsel kann dann nur von einem ausgebildeten Fachpersonal durchgeführt werden, und zwar bei Elektrizitätszählern allein schon wegen der Gefährdung durch die hohen Nennspannungen und -ströme des Versorgungsnetzes. Der Zählerwechsel ist zeitraubend und verursacht erhebliche Kosten.

Die im Tarif-Kundenbereich übliche turnusmäßige Ablesung der Zähler erfolgt durch speziell geschultes Personal oder aber vorläufig durch Zusendung einer Postkarte, die der Kunde nach Übertragung der aktuellen Zählerstände an den Netzbetreiber zurücksendet. Aber auch in den Fällen einer vorläufigen Zählerablesung ist eine turnusmäßige Ablesung der Zähler durch speziell geschultes Personal notwendig, was ebenfalls erhebliche Kosten verursacht.

Aufgabe der Erfindung ist es, einen Verbrauchszähler aufzuzeigen, der diese Nachteile vermeidet. Zur Lösung dieser Aufgabe ist ein Verbrauchszähler entsprechend dem Patentanspruch 1 ausgebildet.

"Hochintegrierte Bauform" bedeutet im Sinne der Erfindung, dass der aktive Teil des Meßmoduls von einem einzigen oder von nur wenigen integrierten Schaltkreisen gebildet ist, wobei diese Schaltkreise dann ähnlich einer Chip- oder Geldkarte in einem kartenartigen Träger untergebracht sind, der problemlos gelagert und auch gehandhabt oder transportiert bzw. versandt werden kann, beispielsweise auch auf dem üblichen Postweg.

Weiterbildungen der Erfindung sind Gegenstand der Unteransprüche. Die Erfindung wird im Folgenden anhand der Figuren am Beispiel eines Elektrizitätszählers näher erläutert.

Es zeigen:
- Fig. 1: in vereinfachter Prinzip-Darstellung einen Elektrizitätszähler gemäß der Erfindung;
- Fig. 2: das Blockschaltbild des Elektrizitätszählers der Fig. 1.

Der in den Figuren allgemein mit 1 bezeichnete Elektrizitätszähler besteht unter anderem aus dem Zählergehäuse 2, in welchem die wesentlichen Funktionselemente des Zählers 1 untergebracht sind, sowie aus einem mit dem Zählergehäuse 2 einstückig hergestellten Klemmengehäuse 2 über dessen Klemmenblock der Elektrizitätszähler 1 in der üblichen Weise an das Versorgungsnetz mit den üblichen Netzspannungen von 230 V/400 V und Nennströmen von 10 A sowie eventuell Grenzströmen bis zu 100 A angeschlossen ist. Der Zähler 1 ist beispielsweise in einer Kundenanlage fest installiert oder aber in einem Hausanschlußkasten integriert.

Im Zählergehäuse 1 ist unter anderem ein Meßwandler 4 zur Signalanpassung untergebracht, mit dem die den Verbrauch bestimmenden physikalischen Größen (zu messende Netz- bzw. Istspannung und zu messenden Ströme) in proportionale anologe oder bevorzugt digitale elektrische Meßwerte transformiert werden, deren Spannungen deutlich unter der Nennspannung des Versorgungsnetzes liegen, beispielsweise in der Größenordnung von nur einigen Volt.

Die so durch Transformation gewonnenen Meßwerte werden in einem ebenfalls im Zählergehäuse 2 untergebrachten Meßmodul 5 verarbeitet und zu den Verbrauchswerten summiert, die dann in der ebenfalls dem Zählergehäuse 1 untergebrachten Meßwertanzeige 6 angezeigt werden. Auch die von dem Meßmodul an die Meßanzeige 6 gelieferten Verbrauchswerte sind bei digitaler Ausbildung dieser Meßwertanzeige bevorzugt solche in digitaler Form.

Die Verarbeitung der von dem Meßwandler 4 gelieferten Meßwerte erfolgt im Meßmodul 5 beispielsweise auch unter Berücksichtigung von Parametern, die in einem Speicher des Meßmoduls abgelegt sind und einen mit dem jeweiligen Abnehmer oder Kunden vereinbarten Tarif, d.h. ein entsprechendes Tarifmodul definieren.

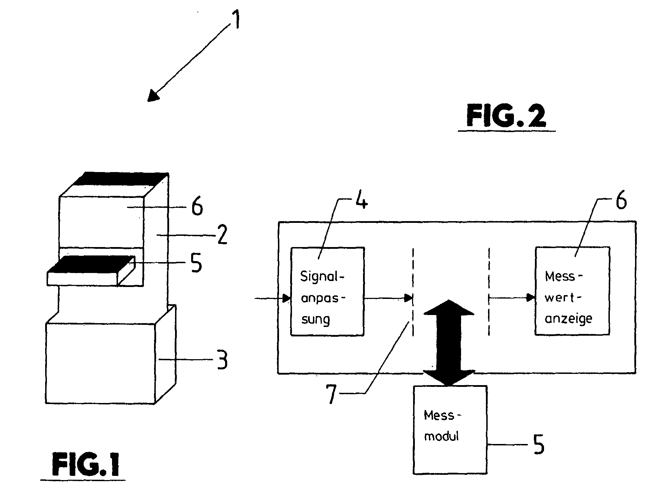

Eine Besonderheit des Elektrizitätszählers 1 besteht nun darin, dass das Meßmodul 5 auswechselbar vorgesehen ist, und zwar in einer in der Figur 2 schematisch mit 7 angedeutete Aufnahme des Zählergehäuses 2.

Da das Meßmodul 5 nur Signale mit extrem niedriger Spannung verarbeitet, kann dieses Modul 5 hoch integriert und mit sehr kleinen Abmessungen und mit sehr kleinem Bauvolumen realisiert werden, beispielsweise als monolithischer integrierter Halbleiterschaltkreis, der dann wie bei einer Chipkarte auf oder in einem kartenartigen Träger vorgesehen ist. Auch andere Bauformen sind denkbar.

Beim Ablaufen der Eichgültigkeit, aber auch bei einem Defekt ist es nicht mehr erforderlich, den gesamten Zähler 1 zu wechseln. Es erfolgt vielmehr lediglich ein Wechseln des Meßmoduls 5. Dieser Wechsel kann von einem autorisiertem Fachpersonal vorgenommen werden. Bei entsprechender Ausbildung des Zählers 1 und/oder der Kundenanlage kann dieser Wechsel sogar durch den Kunden selbst durchgeführt werden. Der Meßwandler 4 und auch die Meßanzeige 6 verbleiben in der Kundenanlage, da zumindest nach dem derzeit geltenden Eichrecht der Meßwandler 4 nur einmal geeicht werden muß und keinen Nacheichfristen unterliegt.

Da die Kosten des Meßmoduls 5 weit unter den Kosten des gesamten Elektrizitätszählers 1 liegen, können bei einem erforderlichen Wechsel des Meßmoduls 5 erhebliche Investitionskosten, aber auch Arbeitskosten eingespart werden, zumal der Austausch des Meßmoduls 5 schnell und problemlos durchgeführbar ist, und zwar ohne Hantieren an Leitern, Leitungen, Kontakten usw., die hohe Spannungen führen.

Durch die hoch integrierte und kleinvolumige Bauform kann das Meßmodul 5 raumsparend gelagert und transportiert werden, insbesondere sind auch ein Transport oder eine Verteilung dieses Meßmoduls auf dem üblichen Postweg möglich.

Ist der Zähler so ausgebildet, dass auch auf ihm der Verbrauch eindeutig und sicher gespeichert bzw. abgelegt ist, dann ist eine besonders einfache Abrechnung in der Weise möglich, dass der jeweilige Kunde von dem Stromversorger vor Ablauf des Abrechnungszeitraumes ein Meßmodul mit leerem "Zählerstand" zugesandt wird. Das im Zähler 1 vorhandene Meßmodul wird gegen dieses neue Meßmodul ausgetauscht und an den Netzbetreiber zur Abrechnung zugesandt.

Es besteht weiterhin auch die Möglichkeit, im Zähler 1 mehrere Meßmodule 5 unterschiedlicher Anbieter bzw. Netzbetreiber vorzusehen und den Zähler 1 so auszubilden, dass ein Umschalten zwischen diesen Meßmodulen 5 beispielsweise entsprechend den mit den einzelnen Netzbetreibern vereinbarten Abnahmezeiten erfolgt.

Die Erfindung wurde voranstehend an einem Ausführungsbeispiel beschrieben. Es versteht sich, dass zahlreiche Änderungen sowie Abwandlungen möglich sind, ohne dass dadurch der der Erfindung zugrunde liegende Erfindungsgedanke verlassen wird.

### Bezugszeichenliste

- 1: Verbrauchszähler
- 2: Zählergehäuse
- 3: Klemmengehäuse
- 4: Signal- oder Meßwandler
- 5: Meßmodul
- 6: Meßwertanzeige
- 7: Aufnahme für Meßmodul

## Patentansprüche

1. Verbrauchszähler, insbesondere Elektrizitätszähler, mit einem Signal- oder Meßwandler (4), der an seinem Ausgang dem Verbrauch entsprechende Meßwerte an ein Meßmodul (5) liefert, welches diese Meßwerte zu abrechnungsrelevanten Verbrauchswerten verarbeitet, **dadurch gekennzeichnet, dass** das Meßmodul hoch integriert und austauschbar in eine Aufnahme (7) des Zählers (1) vorgesehen ist.

2. Verbrauchszähler nach Anspruch 1, **dadurch gekennzeichnet, dass** der Signalwandler (4) Meßwerte in digitaler Form liefert.

3. Zähler nach einem der vorhergehenden Ansprüche, **dadurch gekennzeichnet, dass** im Zähler bzw. an der Aufnahme (7) für das wenigstens eine Meßmodul (5) weiterhin eine Meß- oder Verbrauchswertanzeige (6) vorgesehen ist.

4. Verbrauchszähler nach einem der vorhergehenden Ansprüche, **dadurch gekennzeichnet, dass** mehrere Aufnahmen (7) für mehrere Meßmodule (5) vorgesehen sind.

5. Zähler nach einem der vorhergehenden Ansprüche, **dadurch gekennzeichnet, dass** das Meßmodul (5) wenigstens einen Speicher zur Speicherung der Verbrauchswerte aufweist.

6. Zähler nach einem der vorhergehenden Ansprüche, **dadurch gekennzeichnet, dass** das Meßmodul (5) von wenigstens einem integriertem Halbleiterschaltkreis gebildet ist.

7. Zähler nach einem der vorhergehenden Ansprüche, **dadurch gekennzeichnet, dass** das Meßmodul (5) von wenigstens einem auf oder in einem kartenartigen Träger vorgesehenen integrierten Schaltkreis gebildet ist.
